(19)

Europäisches Patentamt

European Patent Office

Office européen des brevets

(11) **EP 4 572 144 A1**

(12) **EUROPEAN PATENT APPLICATION**

(43) Date of publication:
**18.06.2025 Bulletin 2025/25**

(21) Application number: **24215327.8**

(22) Date of filing: **26.11.2024**

(51) International Patent Classification (IPC):
**H03K 17/18** (2006.01)

(52) Cooperative Patent Classification (CPC):
**H03K 17/18; H02M 1/08; H02M 1/32; H02P 29/02**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **14.12.2023 IT 202300026679**

(71) Applicant: **STMicroelectronics International N.V.**
**1228 Plan-les-Ouates, Geneva (CH)**

(72) Inventors:
• **DE VITA, Placido**
**I-95022 Aci Catena (Catania) (IT)**
• **TORRISI, Giovanni Luca**
**I-95022 Aci Catena (Catania) (IT)**
• **ABBISSO, Salvatore**
**I-96011 Augusta (Siracusa) (IT)**
• **LEONE, Antonio Davide**
**I-27010 Siziano (Pavia) (IT)**
• **DONZELLI, Gea**
**I-21042 Caronno Pertusella (Varese) (IT)**
• **MANCONI, Claudio**
**I-07100 Sassari (IT)**

(74) Representative: **Buzzi, Notaro & Antonielli d'Oulx S.p.A.**
**Corso Vittorio Emanuele II, 6**
**10123 Torino (IT)**

(54) **METHOD FOR CONTROLLING A PLURALITY OF HALF-BRIDGES AND CORRESPONDING APPARATUS**

(57) A method for controlling a plurality of half-bridges (HB1...HB$_N$), said controlling comprising, upon occurrence of a given condition, in particular an anomalous behavior, performing a shut-down (203) of at least a half-bridge (HB$_i$) in said plurality of half-bridges (HB1...HB$_N$), characterized in that said method comprises:

associating (201) to each half-bridge (HB$_i$) of said plurality of half-bridges ((HB1...HB$_N$) a corresponding register (R$_i$) storing a link information (K) indicating which other half-bridge or half-bridges in said plurality of half-bridges (HB1...HB$_N$) is linked to said half-bridge (HB$_i$),

decoding (202) said link information (K) obtaining a decoded link information indicating which other half-bridge or half-bridges in said plurality of half-bridges (HB1...HB$_N$) is linked to said half-bridge (HB$_i$),

performing said shutting down (203) on said at least half-bridge (HB$_i$) and on the other half-bridge or half-bridges in said plurality of half-bridges (HB1...HB$_N$) indicated as linked to said half-bridge (HB$_i$) by said decoded link information.

Fig. 3

## Description

Technical field

The embodiments of the present disclosure relate to a method for controlling a plurality of half-bridges, said control comprising, upon occurring a given condition, in particular a failure condition, performing a shut-down of at least a half-bridge in said plurality of half-bridges.

In particular, these solutions are applied to control of half-bridges driving in a H-bridge configuration loads such as driving electrical motors.

Description of the prior art

In the state of art are known several applications which involve a pre-driving stage which controls the operation of one or more external switches, which in their turn drive a load, e.g., the motor of an actuator. In particular, it is well known to have switches in configuration of H-bridges or half-bridges to drive a load; their control signals, in particular, being supplied to their control electrode by a pre-driving stage.

Here as pre-driver or pre-driving stage is intended an integrated circuit controlling and driving a power stage, comprising such one or more external switches, in particular in H-bridge configuration, not embedded in the same integrated circuit, i.e., in the same chip. Therefore, with external switch is intended a switch belonging to a circuit arrangement differently packaged with respect to the pre-driving stage, i.e., on another integrated circuit or chip. This type of arrangement with a pre-driving and the power stage i.e., the external switch on different chips, may occur for instance with several actuators, using DC electric motors, for instance in the automotive field.

The solutions known in the art can either shut down the entire plurality of half-bridges or shut down only the defective half-bridges, for instance through the driving stage.

These solutions however do not allow to select and deactivate half-bridges among a plurality of half-bridges, enabling shutting down a designated subset of half-bridges in case of failure, instead of shutting down the whole plurality of half-bridges connected to a pre-driving stage, or shutting down the faulty half-bridges only.

Object and summary

Considering the foregoing, an object of various embodiments of the present disclosure is to provide solutions that are able to overcome one or more of the limits of the prior art.

According to one or more embodiments, one or more of the previous objects are achieved by a selective fail-safe method for H-bridges having the distinctive elements specified in the ensuing claims.

The claims form an integral part of the technical teaching of the disclosure provided herein. As mentioned previously, various embodiments of the present disclosure regard a method for selecting, among a plurality of half-bridges connected to a pre-driving stage, a subset of half-bridges and for shutting down the selected half-bridges in case one or more of them show an anomalous behavior.

In order to achieve the desired effect, the solution here described refers to a method for controlling a plurality of half-bridges, comprising, if it is requested, shutting down at least a half-bridge in said plurality of half-bridges, said method comprising the steps associating values to each half-bridge connected to the pre-driving stage, grouping the half-bridges according to the associated values and shutting down, in case an anomaly is detected, the desired subset of half-bridges i.e., the subset of half-bridges driving a faulty load or a subset of half-bridges driving a load wherein a half-bridge is faulty, for instance.

Brief Description of the Drawings

- Figure 1 shows a block schematic representing an embodiment of an apparatus according to the solution here described;
- Figure 2 shows a flow diagram representing an embodiment of a method for controlling a plurality of half-bridges according to the solution here described;
- Figure 3 shows schematically a first embodiment of a logic module according to the solution here described;
- Figure 4a shows schematically a second implementation of a decoding and linking unit according to the solution here described;
- Figure 4b shows a further schematic representation of the decoding and linking unit of Figure 4a;
- Figure 4c shows a further schematic representation of the decoding and linking unit of Figure 4a;
- Figure 5a shows schematically a third implementation of a decoding and linking unit according to the solution here described;
- Figure 5b shows a further schematic representation of the decoding and linking unit of Figure 5a;
- Figure 6a shows a detailed representation of the decoding and linking unit of Figures 4a, 4b, 4c;
- Figure 6b shows a schematics of a combinational circuit comprised in the decoding and linking unit.

Detailed Description of Illustrative Embodiments

In the ensuing description, various specific details are illustrated, aimed at providing an in-depth understanding of the embodiments. The embodiments may be provided without one or more of the specific details, or with other methods, components, materials, etc. In other cases, known structures, materials, or operations are not illustrated or described in detail so that various aspects of the embodiments will not be obscured.

Reference to "an embodiment" or "one embodiment" in the framework of the present disclosure is intended to indicate that a particular configuration, structure, or characteristic described in relation to the embodiment is comprised in at least one embodiment. Hence, phrases such as "in an embodiment" or "in one embodiment" that may be present in various points of this description do not necessarily refer to one and the same embodiment. Moreover, particular conformations, structures, or characteristics may be combined in any adequate way in one or more embodiments.

The references used herein are provided only for convenience and hence do not define the sphere of protection or the scope of the embodiments.

As explained previously, various embodiments of the present disclosure regard a pre-driving stage implementing a selective fail-safe method for H-bridges.

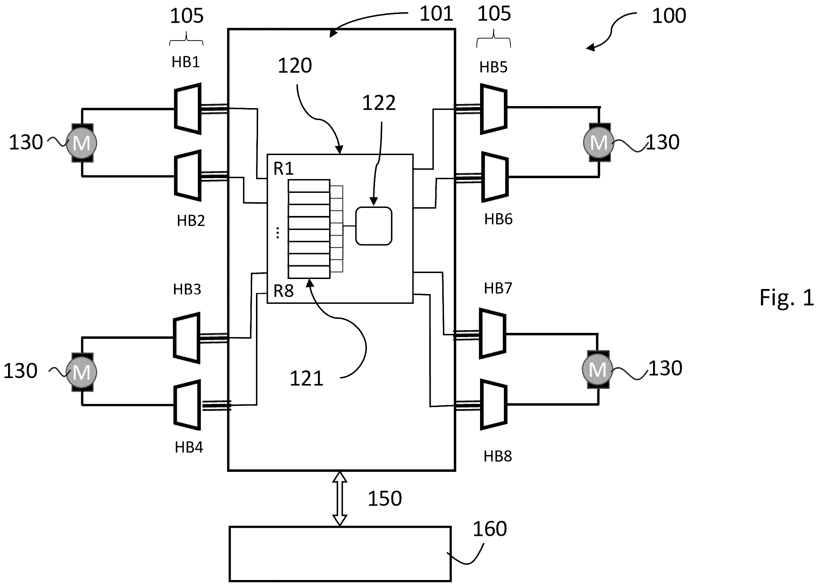

To this end, in Figure 1 it is shown an apparatus 100 comprising a driving stage 101 configured to drive a plurality of half-bridges HB1...HB8, or in general HB1...HBN if there are N half-bridge circuits, collectively indicated by the reference 105. In general, in a way known per se, a half-bridge comprises a high-side switch and a low-side switch, which are driven in their opening and closing state by control signals issued for instance by the driving stage 101. Such switches may be solid-state devices such as, for instance, bipolar transistors, e.g., BJT (Bipolar Junction Transistor), or IGBT (Insulated Gate Bipolar Transistor) or field-effect transistors, e.g., FET (Field Effect Transistor) or MOSFET (Metal Oxide Semiconductor Field Effect Transistor). The half-bridges HB1...HB8 are in the exemplary embodiment arranged in pairs, as shown in Figure 1, in order to form H-bridges for driving a respective load 130, which in the example is embodied by as an electric motor, by its two terminals. The driving stage 101 is configured to supply driving signals to the control electrodes of the switches i.e., to the base electrode of a BJT or to the gate electrode of an IGBT or FET.

The driving stage 101 comprises a logic module 120, which is configured to implement a method by the solution here described, in particular performing linking and decoding operations. As better described in the following, the logic module 120 is configured to couple multiple half-bridges together, in order to allow switching off a desired subset of half-bridges within the plurality of half-bridges HB1...HB8. Such subset can also correspond to the whole plurality of half-bridges HB1...HB8. As shown in Figure 1, which further details such logic module 120 configured to decode and link, the module 120 comprises a plurality of registers, collectively indicated with the reference 121, R1...R8 associated to the corresponding half-bridges HB1...HB8, designed to store as link information a respective key value K associated to each half-bridge HB1...HB8. As better described in the following, the key values K in such registers R1...R8 define how the respective half-bridges HB1...HB8 are linked with respect to a given operation, controlled by the pre-driving stage 101, specifically a shutdown operation, according to the format in which the values K are stored and to the decoding modes implemented in the logic module 120, for instance in a logic subunit or sub-module 122, as shown in Figure 1, whose configuration may vary according to the various embodiments and will be presented in the following.

The driving stage 101 is preferably controlled by an external controller, in Figure 1 it is shown equipped with a Serial Peripheral Interface (SPI), indicated with 150, through which the driving stage 101 can exchange data and control information with an external microcontroller 160.

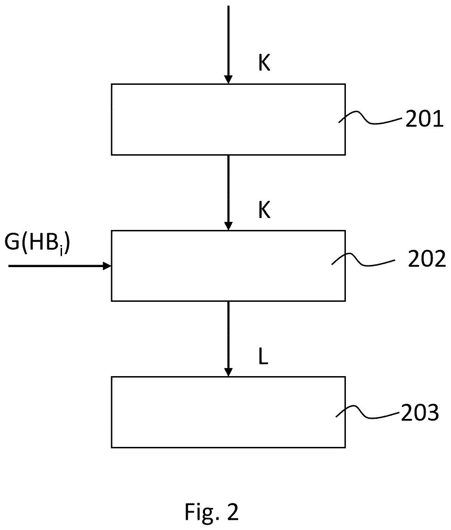

With reference to Figure 2, the driving stage 101 implements a method, indicated as a whole with the reference 200, for controlling a plurality of half-bridges, such as HB1...HB8, which comprises a step 201 of associating to each half-bridge $HB_i$, where i is an index designating a specific half-bridge in said plurality HB1...HB8, of said plurality of half-bridges HB1...HB8, a corresponding register $R_i$ in the plurality of registers R1...R8 in the logic module 120, storing a respective key value K, i.e. a link information indicating which other half-bridge or half-bridges in said plurality of half-bridges HB1...$HB_8$ is linked to said half-bridge $HB_i$, i.e. linked to execute together a shut-down. Such respective key value K specifies a link between such half-bridge $HB_i$ and any of the other half-bridges in said plurality of half-bridges, HB1...HB8.

Then, upon occurrence of a given condition such as an anomaly of at least a given half-bridge, e.g. $HB_i$, requiring shut down, indicated with G(HBi), it is performed a step of decoding 202 such value K, by means of the logic module 120 to obtain such link, indicated with L in Figure 2, between such half-bridge $HB_i$ and any of the other half-bridges in said plurality of half-bridges HB1...HB8. As better explained in the following, the value K in the registers R1...R8 may represent such link L by its position in the register, which is then decoded by the module 120, or may represent a pointer, e.g. an address, to another half-bridge in such plurality which is then acquired by the module 120 to evaluate the link which represents, or may represent an key value representing and identifier of the half-bridge which may be acquired by the unit 120 to compare with possible other identifiers to evaluate the link information L which represents.

In embodiments, the decoding circuitry is combinatory thus the link information L, in particular decoded linking information L maybe available as soon as the configuration in the registers is set or changed.

Then, an operation of shutting down 203 such any other half-bridge linked to such half-bridge $HB_i$ ac-

cording to said obtained i.e., decoded, link information L, is performed. It is underlined that the value K may also indicate that no other half-bridge is linked to the half-bridge storing the value K which is decoded.

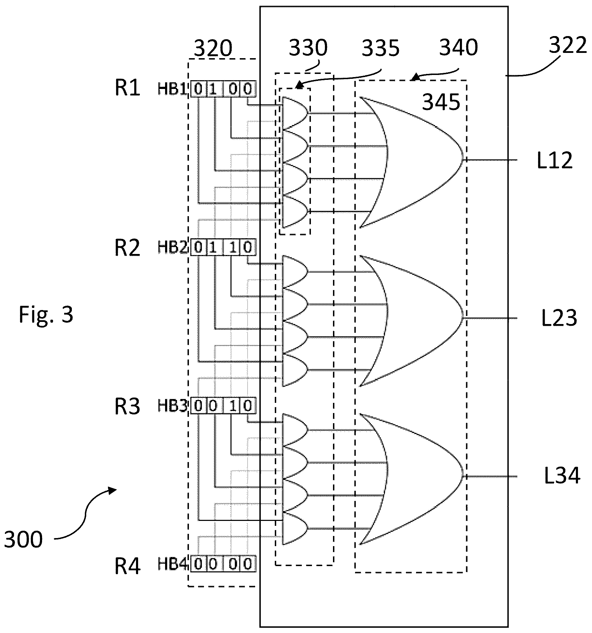

In one exemplary preferred embodiment, illustrated in Figure 3, an embodiment of the logic module 122, indicated with 300, using registers 320 storing keys K, in particular representing identifiers, for grouping the half-bridges in subsets with the same key value K is shown. The logic module 300 comprises then a decoder logic circuit 322, embodying the logic unit 122, comprising a plurality of AND gates 330 and a plurality of OR gates 340. In the exemplary embodiment illustrated in Figure 3, the driving stage 101 is associated to eight half-bridges HB1...HB8 associated to respective registers R1...R8, each register R1...R8 storing a respective key K. However, in Figure 3 a reduced set is shown comprising only four half-bridges HB1 to HB4. Such grouping half-bridges with keys K provides assigning to the half-bridges that are meant to be linked the same key K or identifier i.e., a value, represented as a binary number. In particular in each key K, represented by a binary string, only a single bit is equal to '1' and the remaining bits are equal to '0'.

In view of the above, the number of bits necessary to represent the keys K is equal to the number of keys K used by the method which corresponds to the half the number of half-bridges. In the exemplary embodiment of Figure 3 there are 8 half-bridges, only four of which are illustrated for simplicity., thus a subset of four keys with binary strings of four digits, being equal to, respectively, '0001', '0010', '0100', '1000' may be selected. A further "no key" value may be added to the subset, for instance with the value '0000', which cannot result by the sum of any combination of the previous values, to indicate that the half-bridge storing it is not linked to any other one, e.g., if it is shut down, it is shut down alone.

By further way of example if the plurality of half-bridges comprises 4 half-bridges, the number of bits in a register is 2 and the possible keys are "01" "10".In general, thus it is stored as link information, e.g. as value K, using registers $R_i$, having a length of at least half of the number N of half-bridges, a key value or more key values K belonging to a set of keys $K_0...K_{N/2}$, comprising correspondingly a number of keys half of said number N of half-bridges where, where for instance, Ko may correspond to said "no key" value, e.g., '0000', while each other key in said set $K_0...K_{N/2}$ has a single binary digit asserted, in the example to logic one, different from any other key in said set of keys.

In order to link multiple half-bridges together, it is sufficient to store in the respective registers a key K with the same value.

Each half-bridge can store multiple keys, so that a half-bridge can be shut down if an anomaly occurs in two different subsets of half-bridges to which said half-bridge is linked. Since each key K is represented using only one bit with value equal to '1', a same register may contain multiple keys, such as, for instance, '0001' and '0100', by containing the sum of the two values, '0101' for example.

In order to verify whether two or more half-bridges are linked together, the logic module 300 exploits the plurality of AND gates 330 and the plurality of OR gates 340, arranged to form a combinational logic circuit.

For each i-th register $R_i$ associated to a half-bridge, it is provided a number of AND gates among AND gates 330 corresponding to the number of bits contained in such i-th register $R_i$, e.g., N/2, arranged in subsets 335. Each subset of AND gates 335 is configured to check the link between a pair of half-bridges among the plurality of half-bridges, namely $HB_i$.

Thus, by indicating with N the total number of half-bridges, each register, associated to a half-bridge, is connected to (N - 1) subsets of AND gates 335, each one of said subsets 335 containing, as stated above, a number of AND gates equal to the number of bits in each register, thus enabling a bitwise AND operation. Each register $R_i$, associated to a half-bridge $HB_i$, is thus coupled to a total number of NB × N AND gates, where NB is the number of bits of the register and N is the number of half-bridges of the system.

The link may be independent of the position of a half-bridge $HB_i$, for example HB1 can be linked to HB5 as well. In Figure 3 are illustrated only some examples of the links between the HB to give an idea of the decode logic. Each AND gate of the subset 335 receives two input signals, a first signal corresponding to a bit of a first register $R_i$, at a certain position defined within the register $R_i$, associated to a first half-bridge, and a second signal corresponding to a bit, taken at the same position of the first bit, of a second register $R_j$ associated to a second half-bridge i.e., the registers of a pair of half-bridges.

If the bits stored at the same position of different registers are both equal to '1', i.e., if the different registers store the same key, the result of the AND operation between the two bits returns '1'.

An OR gate 345 receives the output signals coming from the subset of AND gates 335 associated to a pair of registers, and returns an output signal equal to the logical OR operation of the input signals. Thus, each OR gate 345 has a number of inputs equal to the number of bits in each register. By indicating with N the total number of half-bridge, a total number of N × (N - 1) OR gates may be necessary in order to check all the possible couplings between the half-bridge of the pre-driving stage.

However, a further optimization can be achieved, since some links share the same decoding logic (for example, with reference to the notation below, $L_{12} = L_{21}$, where a link information of i-th bridge HBi to j-th bridge HBj is indicated by $L_{ij}$), the real number of OR gates can be obtained using the formula

$$\#OR = \binom{N}{2} = \frac{N!}{2! \cdot (N-2)!}$$ with #OR equal to the number of OR gates and N equals to the number of half-bridges HB. For example, a simple case with 4 HB will have

$$\#OR = \binom{4}{2} = \frac{4!}{2!\cdot(4-2)!} = \frac{4!}{2!\cdot2!} = \frac{3\cdot4}{2!} = 6$$ , corresponding to the six possible links L12, L13, L14, L23, L24, L34. Multiplying the number of OR gates #OR by the size of the keys it is possible to obtain the total number of AND gates (as single gate, not as subset of gates). The total number of AND subsets is equal to the number of OR gates.

The output of the OR gate 345 is asserted, in the example high, if at least one of the input bits is asserted i.e., if the registers corresponding to the half-bridges of which the linking is checked have at least one bit asserted at the same position.

In the example shown, the register 320 of HB1 contains the key K '0100', the register 320 of HB2 contains the key K '0110', the register 320 of HB3 contains the key K '0010' and the register 320 of HB4 contains the key K '0000', thus the OR gate 345 coupled to subset of AND gates 335 coupled to the registers of half-bridges HB1 and HB2 outputs a link information L12 indicating that HB1 and HB2 are linked. The OR gate 345 coupled to subset of AND gates 335 coupled to the registers of half-bridges HB2 and HB3 outputs a link information L23 indicating that HB2 and HB3 are also linked. In general, in the present description a link information of i-th bridge HBi to j-th bridge HBj is indicated by Lij.

It is underlined that if the keys in said set $K_0...K_{N/2}$ has the single binary digit asserted to logic zero, the decoding linking unit 300 of Figure 3 may be embodied for instance changing the AND gates with NOR gates, as AND gate has high output when both inputs are high, NOR gate has high output when both inputs are low. Thus, the step of decoding 202 in variant embodiments may comprise performing bitwise NOR, instead of AND 330, logic operation between the one or more keys K stored in respective registers of a pair of half-bridges i.e., the method here disclosed may comprise performing AND or NOR operations as stage 330, depending on the logic value asserting the link in the binary digits of the keys.

It is noted also that the linking unit 300 of Figure 3 in variant embodiments can achieve the same functionalities for example using only NAND gates using the De Morgan's Law.

Also, in variant embodiments, to change the type of assertion of the link information L at the output e.g., changing from logic zero meaning no link, to meaning link, it is sufficient to change the OR gates with NOR gates as example.

This solution not only allows to select which half-bridge to shut down, but has the advantage that it requires a reduced number of bits, also with respect to the other embodiments here described, and requires a simple combinational logic circuit to implement the logic module 300 performing the decoding and linking. In view of this, this solution requires a reduced amount of die area to implement the method here described.

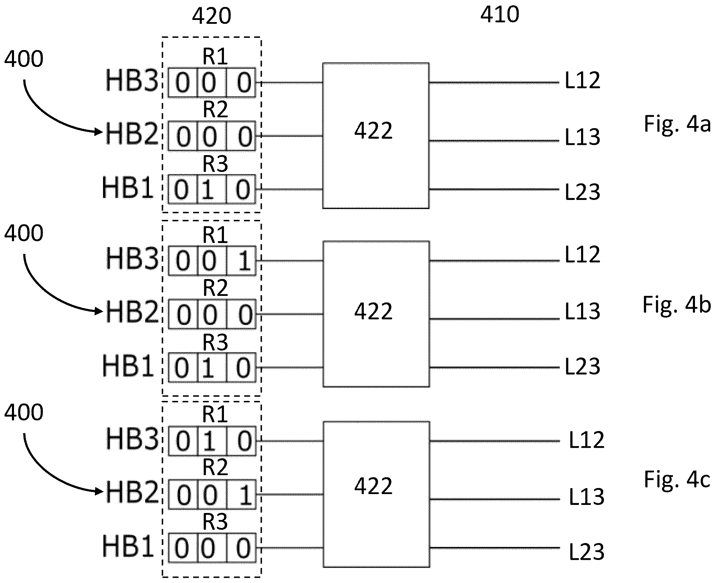

In a further embodiment, illustrated in Figures 4a, 4b, 4c, a logic module 400 using direct half-bridge indexing is shown. The logic module 400 comprises a plurality of registers 420 and a logic unit 422 to decode the value K

The logic module 400 comprises eight half-bridges HB1...HB8 associated to respective registers R1...R8, of which only three are shown here for simplicity's sake.

With reference made to Figure 4a, the register R1, associated to the half-bridge HB1, stores a binary number N1, '010', i.e., an address pointing at the half-bridge HB3, to which this address is associated. The register R2, associated to the half-bridge HB2, stores a binary number N2, '000', i.e., an address pointing at the half-bridge HB1. The register R3, associated to the half-bridge HB3, stores a binary number N3, '000', i.e., an address pointing at the half-bridge HB1.

In this embodiment, the decoding and linking unit 422 comprised in the logic module 400 is configured to rebuild the chain of all the linked half-bridges, that have to be subjected to the same action, e.g., switched off i.e., shut down, simultaneously. Since each register associated to a half-bridge is able to store a value pointing to one, and only one, other half-bridge, the overall linking relationships between the half-bridges must be constructed sequentially by such decoding and linking unit 422.

The binary numbers N1, N2 and N3 are sent as input to the decoding and linking unit 422, which constructs the complete linking relationships of the half-bridges coupled to the pre-driving stage. The decoding and linking unit 422 outputs the linking relationships, indicating, for instance, by a link information L13 outputted by such decoding and linking unit 422, that half-bridge HB1 is linked to half-bridge HB3, half-bridge HB2 is linked to half-bridge HB1 (link information L12). Half-bridge HB3 is linked to half-bridge HB1 as well, thus, HB2 is linked to HB3, indicated in link L23. By applying transitive property, it follows that the half-bridges HB1, HB2 and HB3 are linked together and are consequently turned off simultaneously when required.

Thus, the direct half-bridge indexing provides associating to each half-bridge, in particular its port receiving the control signals from the driving stage, a value K, represented as a binary number, and storing in a register $R_i$ associated to an i-th half-bridge $HB_i$ a value corresponding to the address of another half-bridge $HB_j$ linked to said half-bridge, in such a way that each register associated to a half-bridge contains the address of the linked half-bridge.

In Figure 4b is shown a different configuration of the values K in the three registers of Figure 4a. Here the register R1, associated to the half-bridge HB1, stores a binary number N1, '010', pointing at the half-bridge HB3. The register R2, associated to the half-bridge HB2, stores a binary number N2, '000', pointing at the half-bridge HB1. The register R3, associated to the half-bridge HB3, stores a binary number N3, '001', pointing at the half-bridge HB2.

The binary numbers N1, N2 and N3 are sent as input to the decoding and linking unit 422, which constructs the linking relationships of the half-bridges coupled to the driving stage. The decoding and linking unit 422 outputs the linking relationships, indicating, that half-bridge HB1 is linked to half-bridge HB3 (L13), half-bridge HB2 is linked to half-bridge HB1 (L12) and half-bridge HB3 is linked to half-bridge HB2 (L23). Thus, by applying cyclic association and transitive property, the half-bridges HB1, HB2 and HB3 are linked together and are turned off simultaneously.

In the case in which there is no need to link multiple half-bridges together, it is possible to leave the half-bridges independent by storing in the respective registers an address value that points at the same half-bridge to which the register $R_i$ is associated.

In the configuration of Figure 4c, the register R1, associated to the half-bridge HB1, stores a binary number N1, 000', pointing at the half-bridge HB1. The register R2, associated to the half-bridge HB2, stores a binary number N2, '001', pointing at the half-bridge HB2. The register R3, associated to the half-bridge HB3, stores a binary number N3, '010', pointing at the half-bridge HB3.

In this case, the register configuration shows that HB1, HB2 and HB3 are not connected together, thus the decoding and linking unit 422 indicates that each half-bridge $HB_i$ is linked to itself and not linked to other half-bridges. Link information L12, L13, L23 indicates this e.g., each link information is logic zero, while if a link was present e.g., between HB1 and HB2, the corresponding link information L12 would be logic one.

This solution requires a smaller number of bits to index the plurality of half-bridges, in fact, for each register, a number of bits corresponding to the binary logarithm of the total number of half-bridges is sufficient.

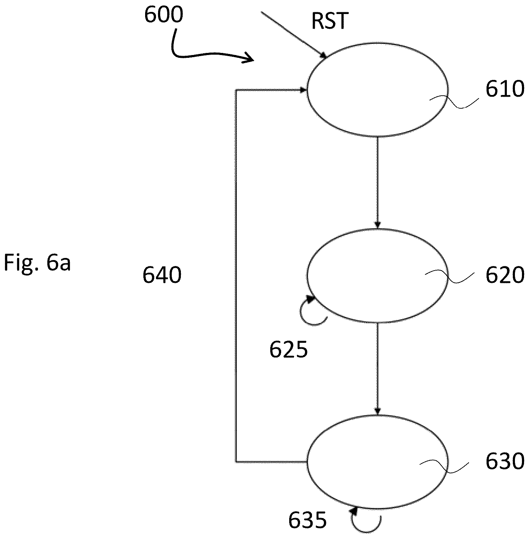

The decoding and linking unit 422 of the present embodiment is now described in further detail. In this regard in Figure 6a an exemplary flow diagram 600 is shown, indicating a procedure to obtain the link information, in the form a link matrix 660, implemented by the decoding and linking unit 422, according to the embodiment here described. For the sake of simplicity, the examples here illustrated are referred to a system driving only four half-bridge stages thus, in accordance with the description in the foregoing, the required number of bits required in register 420 to represent the linking information for each half-bridge stage is two i.e., the binary logarithm of the number of half-bridges connected.

Upon receiving a reset command RST in a first step 610, the decoding and linking unit 422 accesses the values K stored in the register 420 and being indicative of the linking between a half-bridge HBi and a half-bridge HBj, where i is the position of the value K in the register 420 and j is equal to the linked half-bridge index minus one i.e., j = N - 1. The step 610 further comprises initializing a matrix 660 having dimension N × N, with N being the number of half-bridges that the system is designed to control, such matrix 660 being comprised within the decoding and linking unit 422. The initialization of the matrix 660 comprises filling with '0' the off-diagonal cells, and filling with '1' the cells on the diagonal. The content of the register 420 and of the matrix 660 after the first step 610 is reported in the tables below.

| | REGS | |
|---|---|---|
| HB1 | 0 | 1 |
| HB2 | 1 | 0 |
| HB3 | 0 | 0 |
| HB4 | 1 | 1 |

| HBx Matrix | | | |
|---|---|---|---|
| 1 | 0 | 0 | 0 |
| 0 | 1 | 0 | 0 |
| 0 | 0 | 1 | 0 |
| 0 | 0 | 0 | 1 |

Table REGS represents the contents of the register 420, each row representing a half-bridge HBi, comprising a two-bits binary value K, a value for each column. Table HBx Matrix represents the matrix 660 as described above, each row representing a half-bridge HBi, with four columns corresponding to the four values of the binary string corresponding to the half-bridge of that row.

In a second step 620, the values K are read from the register 420, one at a time. In case the value K indicates that a half-bridge HBi is linked with a half-bridge HBj, the decoding and linking unit 422 will write in the matrix 660 a value '1' at the i-th row and j-th column.

Referring to the tables shown above, the values K stored in register 420 are read by the decoding and linking unit 422, starting from the first position of the register, corresponding to HB1. In the example shown, the first position of the register contains value '01', meaning that the half-bridge HB1 is linked to the half-bridge HB2. Consequently, the decoding and linking unit 422 writes a logical '1' value at first row and second column of the matrix 660 (table Create Row1 below, which represent matrix 660 after this first operation), thus indicating that the half-bridge HB1, indicated by the row index of the matrix, is linked with the half-bridge HB2, indicated by the column index of the matrix.

This operation is repeated, as indicated by cycle arrow 625, for each half-bridge (tables Create Row2, Create Row3 and Create Row4 indicate the next three repeat of the operation), this determining, thus starting from HB1 to HB4 in the example shown. At the end of such second step 620, the matrix 660 contains the linking information extracted from register 420 and necessary for reconstructing the complete linking relationships between the plurality of half-bridges.

| Create Row1 | | | |
|---|---|---|---|
| 1 | 1 | 0 | 0 |
| 0 | 1 | 0 | 0 |
| 0 | 0 | 1 | 0 |
| 0 | 0 | 0 | 1 |

| Create Row2 | | | |
|---|---|---|---|
| 1 | 1 | 0 | 0 |
| 0 | 1 | 1 | 0 |
| 0 | 0 | 1 | 0 |
| 0 | 0 | 0 | 1 |

| Create Row3 | | | |
|---|---|---|---|
| 1 | 1 | 0 | 0 |
| 0 | 1 | 1 | 0 |
| 1 | 0 | 1 | 0 |
| 0 | 0 | 0 | 1 |

| Create Row4 | | | |
|---|---|---|---|
| 1 | 0 | 0 | 0 |
| 0 | 1 | 1 | 0 |
| 1 | 0 | 1 | 0 |
| 0 | 0 | 0 | 1 |

Subsequently, in a step 630, the matrix 660 is iteratively symmetrized, starting from the first row. Iteration, i.e. repetition, is indicated by cycle arrow 635. Specifically, the operation of symmetrizing a matrix comprises changing values from '0' to '1', and not vice-versa, in each row of the matrix, in such a way that the resulting matrix is symmetrical i.e., having the i-th row equal to the i-th column. In a first iteration of such operation, as shown in the example, the value located at the first row and third column of the matrix 660 is changed from '0' to '1', in such a way that it is equal to the value stored at the third row and first column of the matrix 660. It must be noted that, as mentioned in the foregoing, only the cells containing values equal to '0' can be changed to '1', whereas cells containing '1' values cannot be changed to '0'. Similarly, in a second iteration of the step 630, the value stored in the cell located at the second row and first column of the matrix 660 is changed from '0' to '1'; in a third iteration of the step 630, the value stored in the cell located at the third row and second column of the matrix 660 is changed from '0' to '1' and, finally, in a fourth iteration of the step 630, no further changes are needed since the fourth row is already equal to the fourth column of the matrix 660. Tables Sym Row1, Sym Row2, Sym Row3, Sym Row4 show matrix 660 after each symmetrization operation.

| Sym Row1 | | | |
|---|---|---|---|
| 1 | 1 | 1 | 0 |
| 0 | 1 | 1 | 0 |
| 1 | 0 | 1 | 0 |
| 0 | 0 | 0 | 1 |

| Sym Row2 | | | |
|---|---|---|---|
| 1 | 1 | 1 | 0 |
| 1 | 1 | 1 | 0 |
| 1 | 0 | 1 | 0 |
| 0 | 0 | 0 | 1 |

| Sym Row3 | | | |
|---|---|---|---|
| 1 | 1 | 1 | 0 |
| 1 | 1 | 1 | 0 |
| 1 | 1 | 1 | 0 |
| 0 | 0 | 0 | 1 |

| Sym Row4 | | | |
|---|---|---|---|
| 1 | 1 | 1 | 0 |
| 1 | 1 | 1 | 0 |
| 1 | 1 | 1 | 0 |
| 0 | 0 | 0 | 1 |

A step 640 may then save the symmetrized matrix and then go back to step 610 for a restart, in particular upon receiving a reset signal RST.

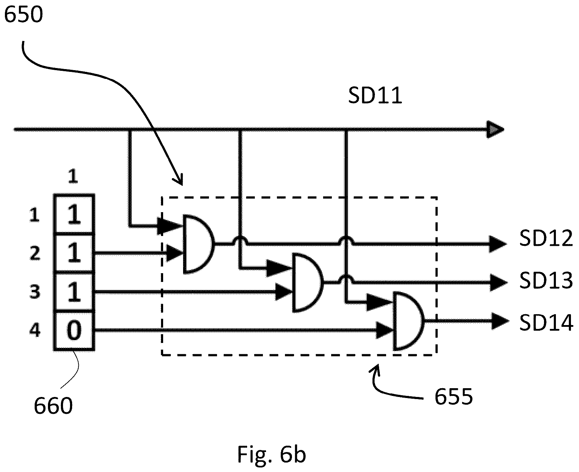

In the exemplary embodiment considered, the decoding and linking unit 422 further comprises a combinational circuit 650 shown in Figure 6b, comprising a plurality of AND gates and configured to check the linking relationships among the plurality of half-bridges. In particular, the combinational circuit 650 comprises a number of AND gates 655 equal to the number of half-bridges supported by the system minus one, N - 1, i.e., three in the example shown. Each AND gate receives two input bits: a first input bit asserting whether a specific half-bridge is to be shut down, and a second input bit coming from the matrix 660, namely of a column indicating the linking of a specific half-bridge, indicated by the column index, in the example 1 for HB1, with the other half-bridge, for which the link must be evaluated, indicated by the row index. It is important to note that for each column of matrix 660, there is a bit that is not connected to the combinational network 650, which is the bit on the row of the specific half-bridge, due to the fact that there is no need to check the linking between a half-bridge and itself.

The output of the AND gates 655 on the basis of the link information contained in the relevant column of the link matrix 660 supplies respective shutdown commands, in binary form, SD12, SD13, SD14, indexes beings chosen in the same way of decoded link information L12, L13, L14.

Thus, the procedure 600 for obtaining the link information as a link matrix e.g., 660, may be summarized as comprising the steps of:

accessing 610 the link information values K stored in the register 420 e.g., the two-bit binary values in such register 420, initializing a square matrix 660, as shown for example initialization meaning filling with zeroes the matrix 660 to the exception of positions on the diagonal;

reading 620 said link information values K from the register 420, one at a time, i.e. a row at time, and writing, asserting a bit value, in the example assertion meaning logic one, at the row and column corresponding to a link information value indicating a link between two given half-bridges, thus position (i,j) for half-bridges $HB_i$ and $HB_j$, repeating said operation for each value, namely each row, in said register 420,

performing 630 an iterative symmetrization of the matrix 660, row by row, such symmetrization comprising changing only not asserting logic values, in the example particular logic zero, in the opposite logic values i.e., logic one, and maintaining asserting logic values, in particular logic one, in other words in the example the zeroes are changed to one and the ones are maintained.

Optionally the procedure may include saving 640 the symmetrized matrix 660 and returning to the accessing step 610, in particular upon receiving a reset signal RST.

The values stored in the matrix 660 are read by the combinational circuit 650, receiving as input bits each column of the matrix 660. In the example illustrated in Figure 6b, when a signal SD11 indicating that the shutdown of half-bridge HB1 is required has a logic high value, the network of AND gates 655 of the combinational circuit 650 returns shutdown commands SD12, SD13, SD14, whether the remaining half-bridges HB2...HB4, indicated by respective row indexes, are required to be shut down along with half-bridge HB1. In the example, the half-bridges HB2 and HB3 are shut down i.e., shutdown commands SD12 and SD13 equals to one, since the first column of the matrix indicated that the half-bridge HB1 is linked to HB2 and HB3. Conversely, the half-bridge HB4 is not shut down in case of fault of HB1 because the matrix indicates that it is not linked to HB1 and then the combinational circuit does not return a signal indicating to shut down such half-bridge, namely shut down command SD14 is asserted to logical zero.

In various embodiments, the decoding and linking unit 422 may be implemented by means of a finite state machine (FSM) or, alternatively, with a microcontroller unit.

This approach requires a more complex decoding and linking unit, with respect to the other embodiments here disclosed, for linking the half-bridges, arising from the fact that the reduced number of bits present in each register 420 allows to specify the linking of a specific half-bridge to one and only one other half-bridge, thus, in order to designate a plurality of half-bridges that must be shut down simultaneously, the sequential chain-linking of multiple half-bridges is necessary.

Thus, in this embodiment, it is possible to obtain the same linking configuration in multiple ways using a reduced number of bits with respect to other embodiments, i.e., smaller registers e.g., 3 bits registers with 8 half-bridges.

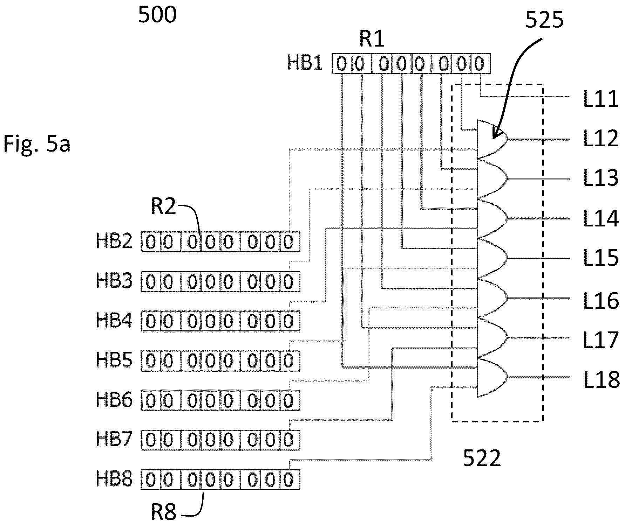

A further embodiment is illustrated in Figure 5a, showing a schematic of an implementation of a logic module 500 using one-hot half-bridge indexing. The one-hot indexing consists in associating, for each register R1...R8, a bit of said register to each half-bridge HB1...HB8 of the driving stage 101. In this embodiment, the registers R1...R8 are indicated as a whole with the reference 510.

In this embodiment, each register $R_i$ associated to a respective half-bridge $HB_i$ comprises a number of bits equal to the maximum number of half-bridges that the driving stage 101 is able to control. Each bit of such register $R_i$, associated to a respective half-bridge $HB_i$, comprises a bit $B_j$ for each half-bridge $HB_i$, i.e., j = 1...8, coupled to the pre-driving stage 101, each bit $B_j$ being representative of the linking between the half-bridge $HB_i$ associated to the register $R_i$ and of a half-bridge $HB_j$ addressed by the bit $B_j$ of said register $R_i$, i.e., associated to the bit $B_j$.

In particular, a j-th bit B in a given register $R_i$ is asserted, e.g. logic one, if the half-bridge $HB_i$ is linked to another half-bridge $HB_j$ identified by the position of the bit $B_j$ in the register Ri; the bit $B_j$ is instead de-asserted if the half-bridge $HB_j$ is not linked to said other half-bridge $HB_j$ identified by the position of the bit $B_j$ in the register $R_j$ and/or if the position of the bit $B_j$ in the register $R_i$ refers to the half-bridge $HB_i$ associated to said register $R_i$.

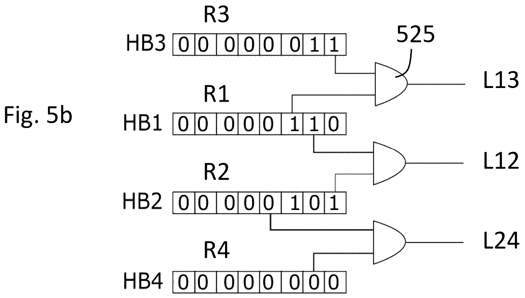

It is underlined that in the example of Figure 5a the values K in the registers R1...R8 are all zeroes i.e., not asserted, for simplicity's sake, while a reduced examples with bit asserted in the values K is given with reference to Figure 5b.

A logic unit 522, embodying in this embodiment the unit 122, of logic module 500 processes the values stored in the registers 510 in order to determine which half-bridges must be shut down in case of a fault. In this exemplary embodiment, the logic unit 522 to this purpose for each i-th half-bridge $HB_i$ (in the example HB1) comprises a plurality of AND gates 525. If N is the number of the half-bridges, in the example N = 8, for each i-th half-bridge $HB_i$ there are N - 1 AND gates 525. Each AND gate in said plurality 520 receives as input a bit of a register $R_i$ associated to such each i-th half-bridge $HB_i$, by a respective port of the pre-driving stage 101, indicating the link to a second j-th half-bridge $HB_j$ among the plurality of remaining half-bridges, in the Figure HB2...HB8 (in general j is an index of the remaining half-bridges, thus it may take every value from 1 to N except j = i). Each AND gate in said plurality of gates 525 receives also at its other input a bit of a register, e.g., $R_j$, associated to a respective j-th half-bridge $HB_j$ among the plurality of remaining half-bridges HB2...HB8, indicating the link of such respective j-th half-bridge $HB_j$ to said i-th first half-bridge HB1, with its position in the register $R_j$. Such arrangement of bits allows to check the link between two half-bridges $HB_i$, $HB_j$ by means of an AND operation between said bits. As mentioned, asserting a bit indicates that a half-bridge, i.e., the control signal through said port, is linked to another half-bridge addressed by the position of such bit in the register, whereas de-asserting a bit means that a half-bridge is not linked to another half-bridge indicated by the position of such bit in the register.

Each register associated to a specific half-bridge comprises a bit that points to the same specific half-bridge and is always de-asserted, due to the fact that linking a half-bridge with itself would not have any useful meaning.

As a result, the AND gate asserts the link between the two half-bridges if both the input bits are asserted, whereas if at least one of the input bits is de-asserted there is no linking between the two half-bridges. This checking procedure must be iterated for each bit of each register present in the unit 500. The outputs of the AND gates 525 may be used by a control unit controlling of the operation of the driving stage 101 to perform a same action, e.g., shut down, on the half-bridges indicated as linked by the signals asserted at such outputs.

It is clear that if there are N half-bridges, there are N instances of the circuit shown in Figure 5a, one for each half-bridge, i.e., there are $7 \times 8 = 56$ AND logic gates.

In Figure 5b it is disclosed a further example of the logic module 500, with four half-bridges, HB1 to HB4, and four respective registers R1 to R4, where in R3 is stored as value K '00000011', in R1 '00000110', in R2 00000101' and in R4 '00000000'. As a consequence, the AND 525 coupling HB1 and HB3 outputs a link information L13 indicating that they are linked, the AND 525 coupling HB1 and HB2 outputs a link information L12 indicating that they are linked while the AND 525 coupling HB2 and HB4 outputs a link information L24 indicating that they are not linked.

This embodiment has the advantage that the circuitry of the decoding and linking logic unit 500 can be kept relatively simple, thanks to the use of AND gates 525 only for checking whether two half-bridges are linked or not, without the need of further operations.

Thus, in general, in view of the disclosure above, present solution provides a method, e.g., 200, for controlling a plurality of half-bridges e.g., N half-bridges HB1...$HB_N$, said controlling comprising, upon occurrence of a given condition, in particular an anomalous behavior, performing a shutdown e.g., step 203, of at least a half-bridge, e.g. i-th half-bridge $HB_i$, in said plurality of half-bridges, e.g., HB1...$HB_N$.

Such method comprises:

associating, e.g. step 201, to each half-bridge, e. g. $HB_i$, of said plurality of half-bridges, e.g., HB1...$HB_N$, a corresponding register, e.g. $R_i$, storing a link information, e.g. a value K, in particular a binary string, indicating which other half-bridge or half-bridges in such plurality of half-bridges, e.g., HB1...$HB_N$ is linked to said half-bridge, e.g., $HB_i$,

decoding, e.g., step 202, said link information K obtaining a decoded link information, e.g., L, indicating which other half-bridge or half-bridges in said plurality of half-bridges HB1...$HB_N$ is linked to said half-bridge $HB_i$, i.e. the one determining the occurrence of the given condition, e.g. anomaly or failure, performing said shutting down, e.g., step 203, on said at least half-bridge $HB_i$ and on the other half-bridge or half-bridges in said plurality of half-bridges HB1...$HB_N$ indicated as linked to said half-bridge $HB_i$ by said decoded link information, e.g., L.

In embodiments, the associating step e.g., 201, comprises storing as link information, K, one or more key values K, e.g. identifiers, belonging to a determined set of keys associated to said plurality of half-bridges HB1...$HB_N$, such set being as explained a subset of the N possible binary keys,

the decoding, e.g., 202, said link information K comprises extracting said one or more keys from the register $R_i$ of at least a half-bridge $HB_i$ and comparing to keys extracted from other registers associated to other half-bridges in said plurality of half-bridges HB1...$HB_N$, i.e. comparing their identifiers, performing said shutting down, e.g., 203) on the half-bridges in which registers are stored the same keys K stored in the register $R_i$ of at least a half-bridge $HB_i$.

Said storing as link information K one or more key values belonging to a determined set of keys associated to said plurality of half-bridges HB1...$HB_N$ comprises using registers having a length of half of the number N of half-bridges in said plurality of half-bridges HB1...$HB_N$, selecting as determined set of keys, a correspondingly number of keys half of said number N of half-bridges in said plurality of half-bridges HB1...$HB_N$, each key in said number of keys having a single binary digit asserted, different from any other key in said subset of keys Of course, a number of keys half of said number N of half-bridges in said plurality of half-bridges $HB1...HB_N$ could be arranged also in register longer than half of the number N of half-bridges, thus in register longer at least half of the number N of half-bridges.

Also, the step of decoding, e.g., 202, comprises performing bitwise AND 330 logic operation between the one or more keys K stored in respective registers of a pair of half-bridges to a plurality of AND gates, e.g., 330, performing logic OR operations, e.g., 340, on each result of a bitwise AND operation, e.g. 335 or collectively 330, of a pair of half-bridges, each OR operation outputting a decoded link information, e.g. L or Lij, indicating if the respective pair of half-bridge is linked or not, in particular the link information L being a binary or two value signal (es, good no good), where assertion means presence of a link, the half-bridges linked have to be shut down together, and de-assertion absence of a link.

Another embodiment, as explained, has the step of associating, e.g., 201 to each half-bridge, e.g., $HB_i$ of said plurality of half-bridges, e.g., $HB1...HB_N$ a corresponding register, e.g., $R_i$ storing a link information, e.g., K, further comprises,

using a corresponding register, e.g., R comprising a number of bits corresponding to a number, e.g., N of said plurality of half-bridges, e.g., $HB1..HB_N$,
associating to each a half-bridge, e.g., $HB_i$, of said plurality of half-bridges, e.g., $HB1...HB_N$ a bit, e.g., B of said respective value stored in said register, e.g., R, said bit, e.g., B being asserted if the half-bridge, e.g., HB1 is linked to another half-bridge, e.g., HB2 identified by the position of the bit, e.g., B in the register, e.g., R, said bit, e.g., B being de-asserted if the half-bridge, e.g., HB1 is not linked to said other half-bridge, e.g., HB2 identified by the position of the bit, e.g., B in the register, e.g., R and/or if the position of the bit, e.g., B in the register, e.g., R identifies to the half-bridge, e.g., HB itself,
decoding, e.g., 202 said link information, e.g., K obtaining a decoded link information indicating which other half-bridge in said plurality of half-bridges, e.g., $HB1...HB_N$ is linked to said half-bridge, e.g., $HB_i$ comprises obtaining as decoded link information the position of one or more asserted bits, e.g., B in the register, e.g., $R_i$ and then performing shutting down the one or more half-bridges identified by the position of said one or more asserted bits, e.g., B.

As shown in figures 5a, 5b, said decoding comprises performing at least an AND operation, e.g., 520 or 525, between a selected bit of a register, e.g. Ri and a selected bit of one or more other registers, e.g. Rj. As shown in Figure 5a selected may mean that each bit of register Ri is AND-ed with the bit which position correspond to it, i.e. Ri, in all the other registers, and this can be replicated to all other registers, performing AND on all the possible combination of bits. Also, as shown in Figure 5b, selected may means that only bits pertaining certain links are brought as input to an AND gate.

The decoding is performed by a simple logic circuit, as described in Figure 5a, using a plurality of AND gates 520, where each AND gate in said plurality 520 receives as input a bit of a register $R_i$ associated to such each i-th half-bridge $HB_i$, by a respective port of the driving stage 101, indicating the link to a second j-th half-bridge $HB_j$ among the plurality of remaining half-bridges, in the Figure HB2...HB8 (in general j is an index of the remaining half-bridges, thus it may take every value from 1 to N except j = i) . Each AND gate in said plurality of gates 525 receives also at its other input a bit of a register, e.g., $R_j$, associated to a respective j-th half-bridge $HB_j$ among the plurality of remaining half-bridges HB2...HB8, indicating the link of such respective j-th half-bridge $HB_j$ to said i-th first half-bridge HB1, with its position in the register $R_j$

In a further embodiment the step of associating, e.g., 201 to each half-bridge, e.g., $HB_i$ of said plurality of half-bridges, e.g., $HB1...HB_N$ a corresponding register, e.g., $R_i$ storing a link information, e.g., K. further comprises:

associating to each half-bridge of said plurality of half-bridges, e.g., $HB1...HB_N$ a respective address value,
storing in said register, e.g., R as link information, e.g., K an address value of another half-bridge, e.g., HB2 to which is linked for shut down, in particular said value, e.g., K having a number of bits equal to the binary logarithm of a number, e.g., N of half-bridges, e.g., N in said plurality of half-bridges, e.g., $HB1...HB_N$,
said decoding, e.g., 202 said link information, e.g., K comprising
reading the addresses value stored in said plurality of half-bridges, e.g., $HB1...HB_N$,
identifying the half-bridges linked by said address values, both directly or linked indirectly through one or more other half-bridge, e.g. indirectly meaning that a chain of link between two half-bridges with interposed one or more other half-bridges can be established,
performing shut down of the half-bridge linked directly or indirectly to the at least a half-bridge, e.g., $HB_i$ to be shut down.

Thus, on the basis of the description above, the operation of the solution here described is clear, as its advantages.

The solution described advantageously provides a more flexible pre-driving circuit, able to deactivate a desired subset of half-bridges if an anomaly is detected, which could be, for example, a subset of half-bridges forming one or more H-bridges driving a load, in such a way that not only a defective half-bridge is switched off, but also the other half-bridges that work in cooperation with the defective half-bridge. In this way it is possible, for instance, to completely turn off a full H-bridge comprising a faulty half-bridge and a working one, thus obtaining a better power efficiency due to the fact that also the working half-bridge is deactivated, thus avoiding to drive the load at a reduced duty cycle. In other cases, wherein an anomaly could occur in the load driven by one or more half-bridges, the present solution allows to conveniently shut down all the half-bridges related to the operation of driving such faulty load, thus avoiding to keep undesired parts of the systems turned on, which may cause increased power consumption and further damage to the system, while keeping contemporarily the working loads and respective half-bridges connected to the same pre-driving stage activated.

Various figures depict circuits and other components with block Figures. These Figures should not be taken to mark the physical boundaries of the corresponding components. As will be appreciated, physical components may be dispersed throughout a SoC.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description. It is therefore intended that the appended claims encompass any such modifications or embodiments.


**Claims**

1.  Method (200) for controlling a plurality of half-bridges (HB1...HB$_N$), said controlling comprising, upon occurrence of a given condition, in particular an anomalous behavior, performing a shut-down (203) of at least a half-bridge (HB$_i$) in said plurality of half-bridges (HB1...HB$_N$), **characterized in that** said method comprises:

    associating (201) to each half-bridge (HB$_i$) of said plurality of half-bridges (HB1...HB$_N$) a corresponding register (R$_i$) storing a link information (K) indicating which other half-bridge or half-bridges in said plurality of half-bridges (HB1...HB$_N$) is linked to said half-bridge (HB$_i$),
    decoding (202) said link information (K) obtaining a decoded link information indicating which other half-bridge or half-bridges in said plurality of half-bridges (HB1...HB$_N$) is linked to said half-bridge (HB$_i$),
    performing said shutting down (203) on said at least half-bridge (HB$_i$) and on the other half-bridge or half-bridges in said plurality of half-bridges (HB1...HB$_N$) indicated as linked to said

half-bridge (HB$_i$) by said decoded link information.

2.  Method (200) according to claim 1, wherein associating (201) to each half-bridge (HB$_i$) of said plurality of half-bridges (HB1...HB$_N$) a corresponding register (R$_i$) storing a link information (K) comprises storing as link information (K) one or more key values (k) belonging to a determined set of keys associated to said plurality of half-bridges (HB1...HB$_N$),
    said decoding (202) said link information (K) comprises extracting said one or more keys from the register (R$_i$) of at least a half-bridge (HB$_i$) and comparing to keys extracted from other registers associated to other half-bridges in said plurality of half-bridges (HB1...HB$_N$), performing said shutting down (203) on the half-bridges in which registers are stored the same keys (K) stored in the register (R$_i$) of at least a half-bridge (HB$_i$).

3.  Method (200) according to claim 2, wherein said storing as link information (K) one or more key values (K) belonging to a determined set of keys associated to said plurality of half-bridges (HB1...HB$_N$) comprises
    using registers having a length of at least half of the number (N) of half-bridges in said plurality of half-bridges (HB1...HB$_N$), selecting as determined set of keys, a number of keys half of said number (N) of half-bridges in said plurality of half-bridges (HB1...HB$_N$), each key in said number of keys having a single binary digit asserted, different from any other key in said subset of keys.

4.  Method (200) according to claim 2 or 3, wherein the step of decoding (202) comprises performing bitwise AND (330) logic operation between the one or more keys (K) stored in respective registers of a pair of half-bridges, performing logic OR operations (340) on each result of a bitwise AND operation (330) of a pair of half-bridges, each OR operation outputting a decoded link information indicating if the respective pair of half-bridge is linked or not.

5.  Method (200) according to claim 1, wherein the step of associating (201) to each half-bridge (HB$_i$) of said plurality of half-bridges (HB1...HB$_N$) a corresponding register (R$_i$) storing a link information (K) indicating which other half-bridge or half-bridges in said plurality of half-bridges (HB1...HB$_N$) is linked to said half-bridge (HB$_i$) further comprises,

    using a corresponding register (R) comprising a number of bits corresponding to a number (N) of said plurality of half-bridges (HB1...HB$_N$),
    associating to each a half-bridge (HB$_i$) of said plurality of half-bridges (HB1...HB$_N$) a bit (B) of said respective value stored in said register (R), said bit (B) being asserted if the half-bridge (HB1) is linked to another half-bridge (HB2) identified by the position of the bit (B) in the register (R), said bit (B) being de-asserted if the half-bridge (HB1) is not linked to said other half-bridge (HB2) identified by the position of the bit (B) in the register (R) and/or if the position of the bit (B) in the register (R) identifies to the half-bridge (HB) itself,

decoding (202) said link information (K) obtaining a decoded link information indicating which other half-bridge in said plurality of half-bridges (HB1...HB$_N$) is linked to said half-bridge (HB$_i$) comprises obtaining as decoded link information the position of one or more asserted bits (B) in the register (R$_i$) and then performing shutting down the one or more half-bridges identified by the position of said one or more asserted bits (B).

6.  Method (200) according to claim 1, wherein said decoding comprises performing at least an AND operation (520) between a selected bit of a register (Ri) among said corresponding registers storing storing a link information (K) and a selected bit of one or more other registers (Rj) among said corresponding registers storing storing a link information (K).

7.  Method (200) according to claim 1, wherein the step of associating (201) to each half-bridge (HB$_i$) of said plurality of half-bridges (HB1...HB$_N$) a corresponding register (R$_i$) storing a link information (K) indicating which other half-bridge or half-bridges in said plurality of half-bridges (HB1...HB$_N$) is linked to said half-bridge (HB$_i$) further comprises:

    associating to each half-bridge of said plurality of half-bridges (HB1...HB$_N$) a respective address value,
    storing in said register (R) as link information (K) an address value of another half-bridge (HB2) to which is linked for shut down, in particular said value (K) having a number of bits equal to the binary logarithm of a number (N) of half-bridges (N) in said plurality of half-bridges (HB1...HB$_N$),
    said decoding (202) said link information (K) comprising
    reading the addresses value stored in said plurality of half-bridges (HB1...HB$_N$),
    identifying the half-bridges linked by said address values, both directly or linked indirectly through one or more other half-bridge,
    performing shut down of the half-bridge linked directly or indirectly to the at least a half-bridge (HB$_i$) to be shut down.

8.  Method (200) according to claim 7, wherein said decoding (202) comprises supplying said read addresses to a decoding and linking unit (422) which is configured to perform said selecting the half-bridges linked directly or linked through one or more other half-bridge.

9.  Method (200) according to claim 8, wherein said decoding (202) comprises obtain the link information as a link matrix (660),

    accessing (610) the link information values (K) stored in the register (420) initializing said link matrix (660);
    reading (620) said link information values (K) from the register (420), one at a time and writing, asserting a bit value at the row and column corresponding to a link information value indicating a link between two given half-bridges, repeating said operation for each value in said register (420),
    performing (630) an iterative symmetrization of said link matrix (660) row by row, such symmetrization comprising changing only not asserting logic values, in particular logic zero, in the opposite logic values and maintaining asserting logic values, in particular logic one,
    optionally saving (640) the symmetrized matrix (660) and returning to the accessing operation (610), in particular upon receiving a reset signal (RST).

10. Method (200) according to any of the previous claims, wherein said given condition to perform a shut-down (203) of at least a half-bridge (HB$_i$) in said plurality of half-bridges (HB1...HB$_N$) comprises detecting (204) if one or more of said half-bridges among the plurality of half-bridges (HB) have an anomalous behavior.

11. Apparatus (100) for controlling a plurality of half-bridges (HB1...HB$_N$) comprising a driving stage (101) arranged for driving one or more loads (130), preferably a DC motor, said apparatus being couplable by a plurality of ports (140) to the plurality of half-bridges (HB1...HB$_N$) to send control signals of the operation of the half-bridges (HB1...HB$_N$);

    said apparatus comprising a logic module (120) comprising a plurality of registers (121) and a logic unit (122)
    said apparatus being configured to implement the method (200) of any of claims 1 to 10.

12. Apparatus (100) according to claim 11, wherein the logic unit (120) comprises an interface (150), preferably a Serial Parallel Interface, SPI, connecting the apparatus (100) to an external microcontroller (160) .

13. Apparatus (100) according to claim 11 or 12, wherein said apparatus comprising a finite state machine (410) to perform said decoding.

14. Apparatus (100) according to claim 12, wherein the plurality of half-bridges (HB1...HB$_N$) is placed externally with respect to the driving stage (101).

15. Apparatus according to claim 12, wherein each port of the plurality of ports (140) is coupled to control terminals of high-side and low-side switches of each half-bridge of the plurality of half-bridges (HB1...HB$_N$), and the control terminals are preferably gate contacts of field effect transistors.

Fig. 1

Fig. 2

EP 4 572 144 A1

Fig. 3

320  330  335  340  322

R1 HB1 0 1 0 0  345

L12

R2 HB2 0 1 1 0

L23

R3 HB3 0 0 1 0

L34

R4 HB4 0 0 0 0

300

Fig. 4a

Fig. 4b

Fig. 4c

EP 4 572 144 A1

Fig. 5a

500

525

R1

HB1 0 0 0 0 0 0 0

L11
L12
L13
L14
L15
L16
L17
L18

R2

HB2 0 0 0 0 0 0 0

HB3 0 0 0 0 0 0 0

HB4 0 0 0 0 0 0 0

HB5 0 0 0 0 0 0 0

HB6 0 0 0 0 0 0 0

HB7 0 0 0 0 0 0 0

HB8 0 0 0 0 0 0 0

R8

522

EP 4 572 144 A1

Fig. 5b

R3
HB3 | 0 | 0 | 0 | 0 | 0 | 0 | 1 | 1

525

L13

R1
HB1 | 0 | 0 | 0 | 0 | 0 | 1 | 1 | 0

L12

R2
HB2 | 0 | 0 | 0 | 0 | 0 | 1 | 0 | 1

L24

R4
HB4 | 0 | 0 | 0 | 0 | 0 | 0 | 0 | 0

Fig. 6a

EP 4 572 144 A1

Fig. 6b

Europäisches
Patentamt

European
Patent Office

Office européen
des brevets

# EUROPEAN SEARCH REPORT

**Application Number**

EP 24 21 5327

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/023080 A1 (CHAMBON PATRICK [FR]) 22 January 2015 (2015-01-22) | 1,2, 10-15 | INV. H03K17/18 |
| A | * paragraph [0034] - paragraph [0035]; figure 3 * * paragraph [0064] * | 3-9 | |
| | - - - - - | | |
| X | US 2014/347103 A1 (SNOOK MARK [GB] ET AL) 27 November 2014 (2014-11-27) | 1,2, 10-15 | |
| A | * paragraph [0009]; figures 1, 2a, 6a * * paragraph [0063] * * paragraph [0121] * * paragraph [0141] * | 3-9 | |
| | - - - - - | | |
| A | US 10 720 919 B2 (ANALOG DEVICES INC [US]) 21 July 2020 (2020-07-21) * column 7, line 64 - column 8, line 10; figures 1a, 2b, 6 * * column 8, line 49 - line 53 * * column 15, line 50 - line 59 * | 1-15 | |
| | - - - - - | | |

**TECHNICAL FIELDS SEARCHED (IPC)**

H03K
H02M
H02P

The present search report has been drawn up for all claims

| Place of search | Date of completion of the search | Examiner |
|---|---|---|
| The Hague | 4 April 2025 | Fermentel, Thomas |

EPO FORM 1503 03.82 (P04C01)

**EP 4 572 144 A1**

## ANNEX TO THE EUROPEAN SEARCH REPORT
## ON EUROPEAN PATENT APPLICATION NO.

EP 24 21 5327

04-04-2025

| Patent document cited in search report | Publication date | Patent family member(s) | | Publication date |
|---|---|---|---|---|
| US 2015023080 A1 | 22-01-2015 | AU | 2012364265 A1 | 24-07-2014 |
| | | CN | 104160601 A | 19-11-2014 |
| | | EP | 2801143 A1 | 12-11-2014 |
| | | US | 2015023080 A1 | 22-01-2015 |
| | | WO | 2013102779 A1 | 11-07-2013 |
| US 2014347103 A1 | 27-11-2014 | CN | 104054265 A | 17-09-2014 |
| | | EP | 2795795 A1 | 29-10-2014 |
| | | GB | 2497967 A | 03-07-2013 |
| | | JP | 6096213 B2 | 15-03-2017 |
| | | JP | 2015509303 A | 26-03-2015 |
| | | KR | 20140113988 A | 25-09-2014 |
| | | US | 2014347103 A1 | 27-11-2014 |
| | | WO | 2013093408 A1 | 27-06-2013 |
| US 10720919 B2 | 21-07-2020 | CN | 105591641 A | 18-05-2016 |
| | | DE | 102015118534 A1 | 12-05-2016 |
| | | US | 2016134278 A1 | 12-05-2016 |

EPO FORM P0459